# EUROPEAN PATENT APPLICATION

(11) **EP 4 236 013 A1**
(43) Date of publication of application: **30.08.2023**
(21) Application number: 22876638.2
(22) Date of filing: 11.07.2022
(51) Int. Cl.: H02J 7/00, G01R 19/165, H01M 10/42

(54) **BATTERY CONTROL SYSTEM AND METHOD**

(30) Priority: 29.09.2021 KR 20210129267
(71) Applicant: LG Energy Solution, Ltd., Seoul 07335 (KR)
(72) Inventor: JEON, Young Hwan, Daejeon 34122 (KR)
(74) Representative: Plasseraud IP
(86) International application number: PCT/KR2022/010039
(87) International publication number: WO 2023/054863

(57) **Abstract**

A battery control system disclosed herein includes a first battery module group, a second battery module group, a first switch configured to connect an end of the second battery module group to a first contactor or open the end of the second battery module group, a second switch configured to connect an end of the first battery module group to the end of the second battery module group or a second contactor, and a battery management system (BMS) connected to the first switch and the second switch, in which the BMS is configured to detect an event for battery structure conversion, control the first switch and the second switch to connect the first battery module group and the second battery module group in series or in parallel, based on the detected event, and adjust a threshold value for battery diagnosis based on whether the first battery module group and the second battery module group are connected in series or in parallel.

## Description

### [Technical Field]

### CROSS-REFERENCE TO RELATED APPLICATION

This application claims priority to and the benefit of Korean Patent Application No. 10-2021-0129267 filed in the Korean Intellectual Property Office on September 29, 2021, the entire contents of which are incorporated herein by reference.

### TECHNICAL FIELD

Embodiments disclosed herein relate to a battery control system and method.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles. A secondary battery is generally used as a battery pack including a battery module where a plurality of battery cells are connected to one another in series and/or in parallel. Battery packs may be managed and controlled by a battery management system in terms of their states and operations.

### [Disclosure]

### [Technical Problem]

A plurality of battery modules (or battery cells) included in a battery pack are configured in either series or parallel. A parallel configuration is available for a long time due to a large battery capacity, but has a low power, whereas a serial configuration has a shorter duration, in spite of a higher power, than the parallel configuration.

Technical problems of the embodiments disclosed herein are not limited to the above-described technical problems, and other unmentioned technical problems would be clearly understood by one of ordinary skill in the art from the following description.

### [Technical Solution]

A battery control system disclosed herein includes a first battery module group, a second battery module group, a first switch configured to connect an end of the second battery module group to a first contactor or open the end of the second battery module group, a second switch configured to connect an end of the first battery module group to the end of the second battery module group or a second contactor, and a battery management system (BMS) connected to the first switch and the second switch, in which the BMS is configured to detect an event for battery structure conversion, control the first switch and the second switch to connect the first battery module group and the second battery module group in series or in parallel, based on the detected event, and adjust a threshold value for battery diagnosis based on whether the first battery module group and the second battery module group are connected in series or in parallel.

An operating method of a battery control system disclosed herein includes detecting an event for battery structure conversion, controlling a first switch and a second switch to connect a first battery module group and a second battery module group in series or in parallel, based on the detected event, and adjusting a threshold value for battery diagnosis based on whether the first battery module group and the second battery module group are connected in series or in parallel, in which the first switch is configured to connect an end of the second battery module group to a first contactor or open the end of the second battery module group, and the second switch is configured to connect an end of the first battery module group to the end of the second battery module group or a second contactor.

### [Advantageous Effects]

A battery control system according to an embodiment disclosed herein may maximize advantages of parallel and serial structures of a battery pack by freely using the parallel and serial structures according to a situation.

The battery control system according to an embodiment disclosed herein may stably perform battery diagnosis in case of change of parallel and serial structures of the battery pack.

### [Description of Drawings]

FIG. 1 is a block diagram of a general battery pack including a battery management apparatus according to various embodiments.
FIG. 2 is a block diagram showing a configuration of a battery control system according to various embodiments.
FIG. 3 is a block diagram showing a serial structure of a battery control system according to various embodiments.
FIG. 4 is a block diagram showing a parallel structure of a battery control system according to various embodiments.
FIG. 5 is an operating flowchart for controlling a battery structure and a threshold according to various embodiments.
FIG. 6 is an operating flowchart for controlling a battery structure and a threshold according to various embodiments.
FIG. 7 is a block diagram showing a computing system that performs a battery management method according to various embodiments.

### [Mode for Invention]

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st, "2nd", "first", "second", or the like may modify various components regardless of importance, and do not limit the components. For example, a first component may be named as a second component without departing from the right scope of an embodiment disclosed herein, and similarly, the second component may be named as the first component.

Terms used in the present document are used for only describing a specific exemplary embodiment of the disclosure and may not have an intention to limit the scope of other exemplary embodiments of the disclosure. It is to be understood that the singular forms include plural references unless the context clearly dictates otherwise.

All terms including technical and scientific terms used herein have the same meaning as commonly understood by one of ordinary skill in the art to which the embodiments disclosed herein belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined herein may be interpreted to exclude embodiments disclosed herein.

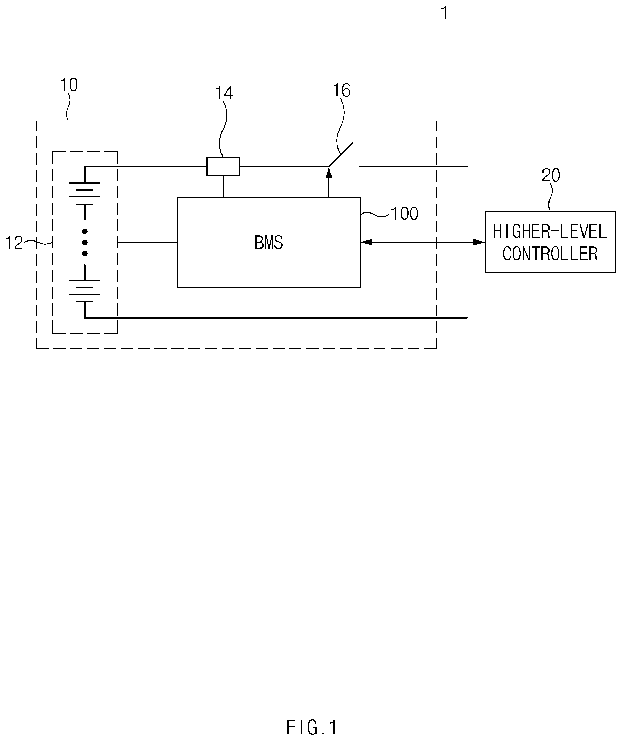

FIG. 1 is a block diagram of a general battery pack including a battery management apparatus according to various embodiments.

More specifically, FIG. 1 schematically shows a battery control system 1 including a battery pack 10 and a higher-level controller 20 included in a higher-level system according to an embodiment disclosed herein.

As shown in FIG. 1, the battery pack 10 may include a plurality of battery modules 12, a sensor 14, a switching unit 16, and a battery management system (BMS) 100. The battery pack 10 may include the battery module 12, the sensor 14, the switching unit 16, and the BMS 100 provided in plural.

The plurality of battery modules 12 may include at least one chargeable/dischargeable battery cells. In this case, the plurality of battery modules 12 may be connected in series or in parallel.

The sensor 14 may detect current flowing in the battery pack 10. In this case, a detected signal may be transmitted to the BMS 100.

The switching unit 16 may be connected in series to a (+) terminal side or a (-) terminal side of the battery module 12 to control the charging/discharging current flow of the battery module 12. For example, the switching unit 16 may use at least one relay, a magnetic contactor, etc., according to the specifications of the battery pack 10.

The BMS 100 may monitor the voltage, current, temperature, etc., of the battery pack 10 to perform control and management to prevent overcharging and overdischarging, etc., and may include, for example, a rack BMS (RBMS).

The BMS 100, which is an interface for receiving measurement values of the above-described various parameter values, may include a plurality of terminals and a circuit, etc., connected thereto to process input values. The BMS 100 may control on/off of the switching unit 16, e.g., a relay, a contactor, etc., and may be connected to the battery module 12 to monitor the state of each battery module 12.

The higher-level controller 20 may transmit a control signal for controlling the battery module 12 to the BMS 100. Thus, the BMS 100 may be controlled in terms of an operation thereof based on a signal applied from the higher-level controller 20. Also, the battery module 12 may be a component included in an energy storage system (ESS). In this case, the higher-level controller 20 may be a controller (a bank BMS (BBMS)) of a battery bank including the plurality of packs 10 or an ESS controller for controlling the entire ESS including a plurality of banks. However, the battery pack 10 is not limited to such a purpose.

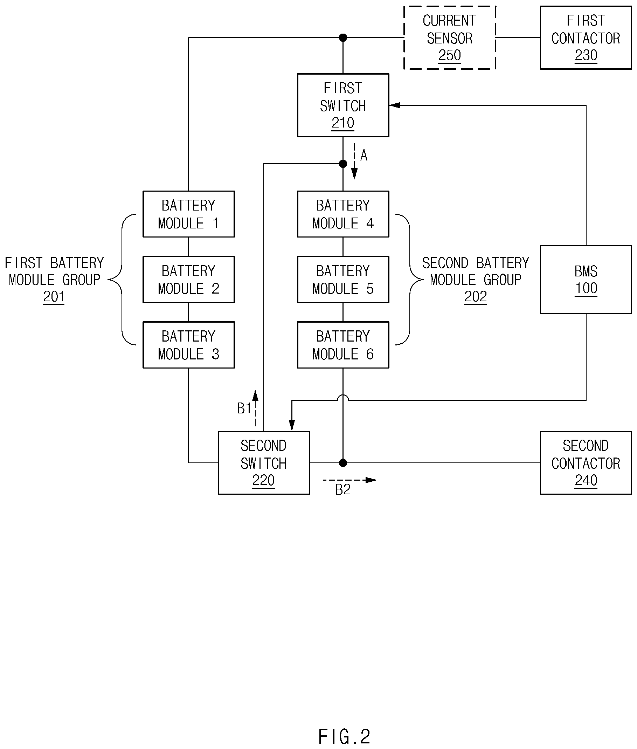

FIGS. 2 to 4 are block diagrams showing a configuration of a battery control system according to various embodiments.

Referring to FIG. 2, a battery control system 1 (or the battery pack 10) may include a plurality of battery modules (battery modules 1 to 6), a first switch 210 and a second switch 220 configured to convert a battery structure in connection with some of the plurality of battery modules, a first contactor 230 and a second contactor 240 connected to the plurality of battery modules, and the BMS 100 connected to each component. According to an embodiment, the battery control system 1 may further include a current sensor 250 between the first contactor 230 and the plurality of battery modules to measure a current.

The plurality of battery modules may be classified into two or more groups. For example, the plurality of battery modules may be classified into a first battery module group 201 including the battery modules 1 to 3 and a second battery module group 202 including the battery modules 4 to 6, but the number of battery modules included in each battery module group and the number of battery module groups are not limited to an example shown in FIG. 2. The following description presumes an embodiment where each battery module includes the same number of battery cells having the same performance, but the performance and number of cells are not necessarily identical.

The first contactor 230 and the second contactor 240 may be a positive contactor and a negative contactor, respectively. For example, when a device (e.g., a vehicle, construction machinery, etc.) including the battery control system 1 is turned on/off, the first contactor 230 and the second contactor 240 may be turned on/off, together. The first contactor 230 may be connected to the first battery module group 201 (e.g., the battery module 1), and the second contactor 240 may be connected to the second battery module group 202 (e.g., the battery module 6).

A first end of the first switch 210 may be connected to the first contactor 230, and a second end of the first switch 210 may be connected to the second battery module group 202 (e.g., the battery module 4) (e.g., a path A). Alternatively, the second end of the first switch 210 may enter an open state with the second battery module group 202 under control of the BMS 100.

A first end of the second switch 220 may be connected to the first battery module group 201 (e.g., the battery module 3), and a second end thereof may be connected to the second battery module group 202 (e.g., the battery module 4) (e.g., a path B1) or the second contactor 240 (e.g., a path B2) under control of the BMS 100.

The BMS 100 may be connected to each component of the battery control system 1 to perform an overall operation of the battery control system 1. While FIGS. 2 to 4 show a structure where the BMS 100 is connected by the switches 210 and 220, the BMS 100 may be further connected to a measurement apparatus (e.g., the current sensor 250) or a plurality of battery modules.

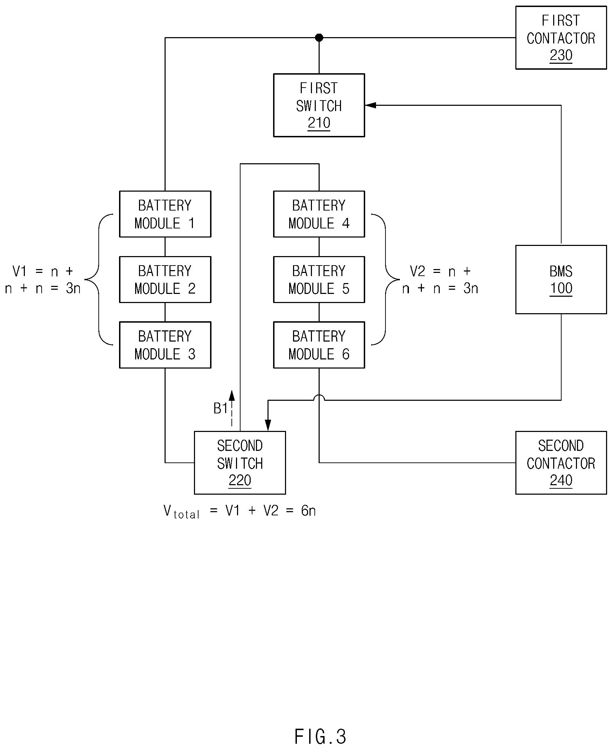

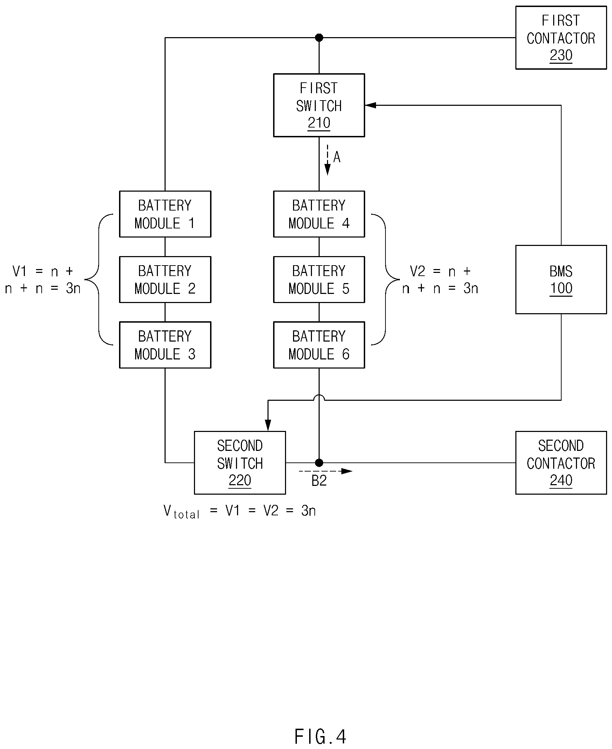

The BMS 100 may control the first switch 210 and the second switch 220 to connect the first battery module group 201 and the second battery module group 202 in series or in parallel. For example, for a serial battery structure, as shown in FIG. 3, the BMS 100 may control the first switch 210 to be in an open state with the second battery module group 202 and the second switch 220 to be connected to the second battery module group 202. In another example, for a parallel battery structure, as shown in FIG. 4, the BMS 100 may control the first switch 210 to be connected to the second battery module group 202 and the second switch 220 to be connected to the second contactor 240.

In an embodiment, the BMS 100 may determine a battery structure to be a serial structure or a parallel structure based on detection of an event for battery structure conversion. For example, the BMS 100 may determine a battery structure to be the parallel structure to increase a battery duration when a battery capacity is less than a designated threshold capacity. In another example, the BMS 100 may determine the battery structure based on a location of the battery control system 1 (or a location of a vehicle). For example, when the vehicle is located in a downtown area, the BMS 100 may determine the battery structure to be the parallel structure to maintain battery performance. On the other hand, the BMS 100 may determine the battery structure to be the serial structure when the battery capacity is greater than or equal to the threshold capacity or the vehicle is not located in the downtown area (e.g., is located on a highway).

In an embodiment, the BMS 100 may adjust a threshold value for battery diagnosis based on the battery structure. For example, assuming that a voltage of each battery module is n (herein, n is an integer), when the battery structure is serial as shown in FIG. 3, a maximum total voltage Vₜₒₜₐₗ of a battery pack is equal to a sum, 6n, of a maximum total voltage V1 of the first battery module group 201 and a maximum total voltage V2 of the second battery module group 202, such that the BMS 100 may determine a threshold value for diagnosing an over-voltage to be a value equal to or greater than 6n. As shown in FIG. 4, when the battery structure is parallel as shown in FIG. 4, a maximum total voltage Vₜₒₜₐₗ of a battery pack is equal to 3n that is the maximum total voltage V1 of the first battery module group 201 (or the maximum total voltage V2 of the second battery module group 202), such that the BMS 100 may determine the threshold value for diagnosing an over-voltage to be a value equal to or greater than 3n. When a current is constant regardless of the battery structure, a battery power decreases with decrease of a battery voltage (PV = V1 wherein P is power, V is voltage, and I is current), such that the BMS 100 according to an embodiment may change a threshold value for over-power measurement according to a battery structure based on the same principle as the threshold value for over-voltage detection. Upon detection of a pack over (e.g., over-voltage or over-power) in the battery pack 10, the BMS 100 may determine a battery state to be fault and stop a battery operation (or a vehicle operation) or output a notification. The BMS 100 may change a threshold value for battery cell diagnosis according to a battery structure based on the same principle as battery diagnosis in the unit of a battery pack. The BMS 100 may change the threshold value by applying the same principle to pack under or over-current.

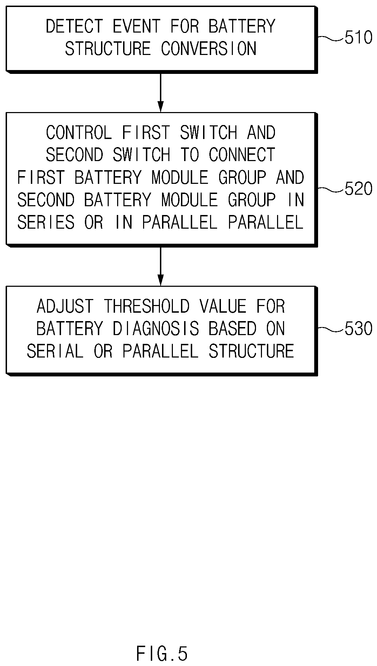

FIG. 5 is an operating flowchart for controlling a battery structure and a threshold according to various embodiments. Operations shown in the operating flowchart may be implemented by the battery control system 1 or a component thereof (e.g., the BMS 100).

Referring to FIG. 5, in operation 510, the battery control system 1 may detect an event for battery structure conversion. According to an embodiment, the battery control system 1 may determine whether the structure of the battery pack 10 is serial or parallel.

In operation 520, the battery control system 1 may control the first switch 210 and the second switch 220 to connect the first battery module group 201 and the second battery module group 202 in series or in parallel, based on the detected event.

In operation 530, the battery control system 1 may adjust a threshold value for battery diagnosis based on the serial or parallel structure of the battery.

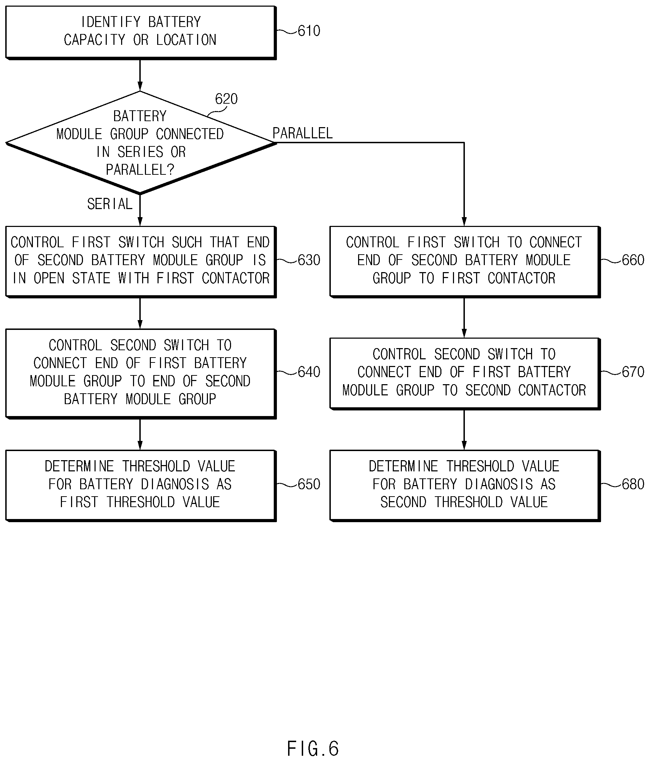

FIG. 6 is an operating flowchart for controlling a battery structure and a threshold according to various embodiments.

Referring to FIG. 6, in operation 610, the battery control system 1 may identify at least one of a battery capacity or a location of the battery control system 1.

In operation 620, the battery control system 1 may determine whether to connect battery module groups (the first battery module group and the second battery module group) in series or in parallel based on the identified value.

When the battery structure is to be serial, the battery control system 1 may control the first switch 210 such that an end of the second battery module group 202 is in an open state with the first contactor340, in operation 630, and control the second switch 220 such that an end of the first battery module group 201 is connected to the end of the second battery module group 202, in operation 640. In operation 650, the battery control system 1 may determine the threshold value for battery diagnosis as a first threshold value.

When the battery structure is to be parallel, the battery control system 1 may control the first switch 210 such that the end of the second battery module group 202 is connected to the first contactor 340, in operation 660, and control the second switch 220 such that the end of the first battery module group 201 is connected to the second contactor 340, in operation 670. In operation 680, the battery control system 1 may determine the threshold value for battery diagnosis as a second threshold value. Herein, the second threshold value may be determined according to a ratio of the first battery module group 201 to the second battery module group 202. For example, when the number of battery modules included in the first battery module group 201 is the same as the number of battery modules included in the second battery module group 202, the battery control system 1 may determine the second threshold value to be a half of the first threshold value (or the half + a wherein a is a margin value).

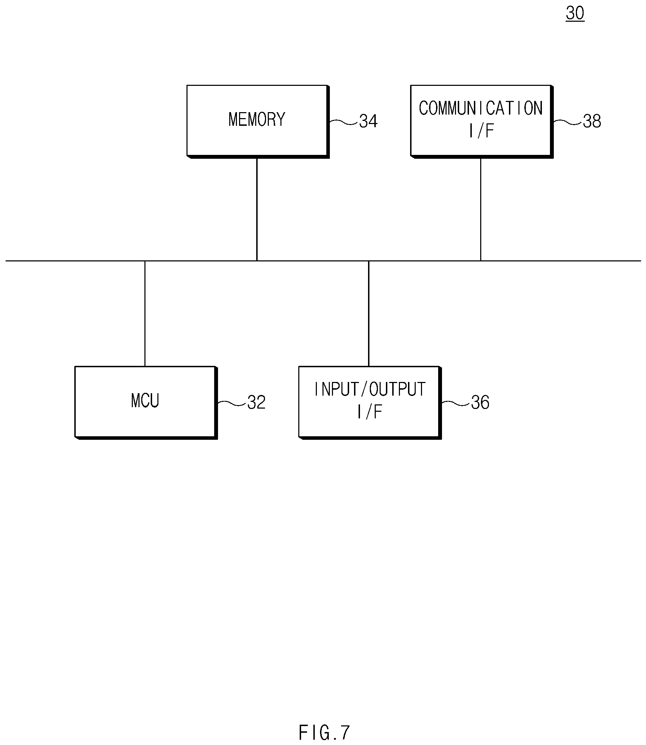

FIG. 7 is a block diagram showing a computing system that performs a battery management method according to various embodiments.

Referring to FIG. 7, a computing system 30 according to an embodiment disclosed herein may include a microcontroller unit (MCU) 32, a memory 34, an input/output interface (I/F) 36, and a communication I/F 38.

The MCU 32 may be a processor that executes various programs (e.g., a feature calculation program, a class classification and lifespan estimation program, etc.) stored in the memory 34, processes various data including voltage, current, etc., of a battery cell through these programs, and executes the above-described functions of the battery management apparatus shown in FIG. 2.

The memory 34 may store various programs regarding feature calculation, class classification, and lifespan estimation of the battery cell. Moreover, the memory 34 may store various data such as a voltage, a current, feature data, etc., of each battery cell.

The memory 34 may be provided in plural, depending on a need. The memory 34 may be volatile memory or non-volatile memory. For the memory 34 as the volatile memory, random access memory (RAM), dynamic RAM (DRAM), static RAM (SRAM), etc., may be used. For the memory 34 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 34 are merely examples and are not limited thereto.

The input/output interface (I/F) 36 may provide an interface for transmitting and receiving data by connecting an input device (not shown) such as a keyboard, a mouse, a touch panel, etc., and an output device such as a display (not shown), etc., to the MCU 32.

The communication I/F 340, which is a component capable of transmitting and receiving various data to and from a server, may be various devices capable of supporting wired or wireless communication. For example, a program for feature calculation, class classification, and lifespan estimation for a battery cell or various data, etc., may be transmitted and received to and from a separately provided external server through the communication I/F 38.

As such, a computer program according to an embodiment disclosed herein may be recorded in the memory 34 and processed by the MCU 32, thus being implemented as a module that performs functions shown in FIG. 1 or 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

## Claims

1. A battery control system comprising:
a first battery module group;
a second battery module group;
a first switch configured to connect an end of the second battery module group to a first contactor or open the end of the second battery module group;
a second switch configured to connect an end of the first battery module group to the end of the second battery module group or a second contactor; and
a battery management system (BMS) connected to the first switch and the second switch,
wherein the BMS is configured to:
detect an event for battery structure conversion;
control the first switch and the second switch to connect the first battery module group and the second battery module group in series or in parallel, based on the detected event; and
adjust a threshold value for battery diagnosis based on whether the first battery module group and the second battery module group are connected in series or in parallel.

2. The battery control system of claim 1, wherein the BMS is further configured to:
determine the threshold value for battery diagnosis as a first threshold value when the first battery module group and the second battery module group are connected in series; and
determine the threshold value for battery diagnosis as a second threshold value that is a half of the first threshold value when the first battery module group and the second battery module group are connected in parallel.

3. The battery control system of claim 2, wherein the threshold value for battery diagnosis comprises a value for determining over-voltage or over-power.

4. The battery control system of claim 1, wherein to connect the first battery module group and the second battery module group in series, the BMS is further configured to:
control the first switch such that the end of the second battery module group is in an open state with the first contactor; and
control the second switch to connect the end of the first battery module group to the end of the second battery module group.

5. The battery control system of claim 1, wherein to connect the first battery module group and the second battery module group in parallel, the BMS is further configured to:
control the first switch to connect the end of the second battery module group to the first contactor; and
control the second switch to connect the end of the first battery module group to the second contactor.

6. The battery control system of claim 1, wherein the BMS is further configured to determine the first battery module group and the second battery module group are connected in series or in parallel, based on at least one of a battery capacity or a location of the battery control system.

7. An operating method of a battery control system, the operating method comprising:
detecting an event for battery structure conversion;
controlling a first switch and a second switch to connect a first battery module group and a second battery module group in series or in parallel, based on the detected event; and
adjusting a threshold value for battery diagnosis based on whether the first battery module group and the second battery module group are connected in series or in parallel,
wherein the first switch is configured to connect an end of the second battery module group to a first contactor or open the end of the second battery module group, and
the second switch is configured to connect an end of the first battery module group to the end of the second battery module group or a second contactor.

8. The operating method of claim 7, wherein the adjusting of the threshold value for battery diagnosis comprises:
determining the threshold value for battery diagnosis as a first threshold value when the first battery module group and the second battery module group are connected in series; and
determining the threshold value for battery diagnosis as a second threshold value that is a half of the first threshold value when the first battery module group and the second battery module group are connected in parallel.

9. The operating method of claim 8, wherein the threshold value for battery diagnosis comprises a value for determining over-voltage or over-power.

10. The operating method of claim 7, wherein the controlling of the first switch and the second switch comprises, to connect the first battery module group and the second battery module group in series, controlling the first switch such that the end of the second battery module group is in an open state with the first contactor and controlling the second switch such that the end of the first battery module group is connected to the end of the second battery module group.

11. The operating method of claim 7, wherein the controlling of the first switch and the second switch comprises, to connect the first battery module group and the second battery module group in parallel, controlling the first switch to connect the end of the second battery module group to the first contactor and controlling the second switch to connect the end of the first battery module group to the second contactor.

12. The operating method of claim 7, wherein the detecting of the event for battery structure conversion comprises determining the first battery module group and the second battery module group are connected in series or in parallel, based on at least one of a battery capacity or a location of the battery control system.
